Europäisches Patentamt

European Patent Office

Office européen des brevets

(19)

(11) Numéro de publication : **0 017 697**
**B1**

(12)    # FASCICULE DE BREVET EUROPÉEN

(45) Date de publication du fascicule du brevet :
02.05.84

(21) Numéro de dépôt : **80100189.2**

(22) Date de dépôt : **16.01.80**

(51) Int. Cl.³ : **H 01 L 21/283**, H 01 L 29/54

(54) **Dispositif d'interconnexions de circuits intégrés semi-conducteurs et son procédé de fabrication.**

(30) Priorité : **01.03.79 US 16647**

(43) Date de publication de la demande :
**29.10.80 Bulletin 80/22**

(45) Mention de la délivrance du brevet :
**02.05.84 Bulletin 84/18**

(84) Etats contractants désignés :
**DE FR GB**

(56) Documents cités :
**EP-A- 0 000 317**
**DE-A- 2 815 605**
**DE-A- 2 817 430**
**DE-A- 2 909 320**
**US-A- 3 667 008**
**US-A- 4 106 051**
**US-A- 4 163 246**
**Patents Abstracts of Japan, Vol. 2, No. 33, 6 mars 1978, pages 12593E77**
**IEEE TRANSACTIONS ON ELECTRON DEVICES, Vol. ED-26, No. 4, avril 1979, New York B. CROWDER et al. "1 um MOSFET VLSI Technology : Part VII — Metal Silicide Interconnection Technology — A Future Perspective"**

(73) Titulaire : **International Business Machines Corporation**
**Old Orchard Road**
**Armonk, N.Y. 10504 (US)**

(72) Inventeur : **Crowder, Billy, Lee**
**Road No. 2, Putnam Valley**
**New York 10579 (US)**
Inventeur : **Reisman, Arnold**
**2294 Van Cortlandt Circle**
**Yorktown Heights New York 10598 (US)**

(74) Mandataire : **Colas, Alain**
**Compagnie IBM France Département de Propriété Industrielle**
**F-06610 La Gaude (FR)**

Jouve, 18, rue St-Denis, 75001 Paris, France

Dispositif d'interconnexions de circuits intégrés semi-conducteurs et son procédé de fabrication

Description

Domaine technique

La présente invention concerne le domaine des circuits intégrés semi-conducteurs, et, plus particulièrement, l'interconnexion des dispositifs intégrés dans un bloc semi-conducteur.

Technique antérieure

Dans l'état actuel de la technique, les structures à circuits intégrés renferment plusieurs dispositifs fabriqués à partir d'un cristal semi-conducteur et comportent des lignes d'interconnexion multi-niveaux disposées au-dessus des dispositifs et au-dessus des régions isolantes de la structure. Les lignes d'interconnexions ont été formées de différentes façons dans l'art antérieur, par exemple par diffusion gazeuse, par dopage à implantation ionique et par l'utilisation de matériau semi-conducteur polycristallin dopé. Cependant, la réduction des dimensions des dispositifs intégrés provoque un accroissement de la résistance à des niveaux affectant sérieusement la performance de ces dispositifs. Il en résulte que le retard dû aux interconnexions des dispositifs intégrés constitue une partie importante et inacceptable du retard total dû aux circuits eux-mêmes. De plus, à mesure que la résistance augmente, les chutes de tension deviennent plus importantes, ce qui rend plus difficile la répartition de puissance et la détection des signaux.

Les avantages présentés par l'utilisation du silicium polycristallin dopé pour la réalisation d'interconnexions dans des circuits intégrés semi-conducteurs sont bien connus dans l'art antérieur et ont été décrits par exemple dans les IBM Technical Disclosure Bulletins, Vol. 20, No. 11A, page 4286, d'avril 1978 ; Vol. 20, No. 2, page 539 de juillet 1977 et Vol. 18, No. 11, page 3840 d'avril 1976.

L'emploi d'interconnexions formées de couches conductrices composites de silicium polycristallin et de siliciure métallique est connu de US-A-4 102 733.

Un siliciure métallique tel que le siliciure de molybdène a été utilisé dans le domaine des semi-conducteurs pour la réalisation de dispositifs discrets, comme indiqué dans le brevet US-A-3 381 182. Cependant, dans ces exemples, le problème posé par l'obtention d'une conductivité élevée tout en contrôlant, en même temps, la capacité associée au chevauchement des conducteurs, n'a pas été résolu.

Exposé de l'invention

La présente invention concerne une technique de fabrication de circuits intégrés dans lesquels les interconnexions sont formées de lignes conductrices composites de silicium polycristallin dopé et de siliciure métallique. Cette combinaison, qui sera ci-après appelée « polyciure », permet d'obtenir simultanément l'avantage d'une conductivité élevée et celui d'une capacité parasite réduite.

D'autres caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 représente un conducteur d'interconnexion intégré au semi-conducteur amélioré.

Les figures 2A à 2C représentent les étapes de fabrication d'un dispositif à effet de champ utilisant un système d'interconnexion conforme à la présente invention.

Les figures 3A à 3E représentent les étapes de fabrication d'un dispositif de mémoire semi-conducteur utilisant le système d'interconnexion conforme à la présente invention.

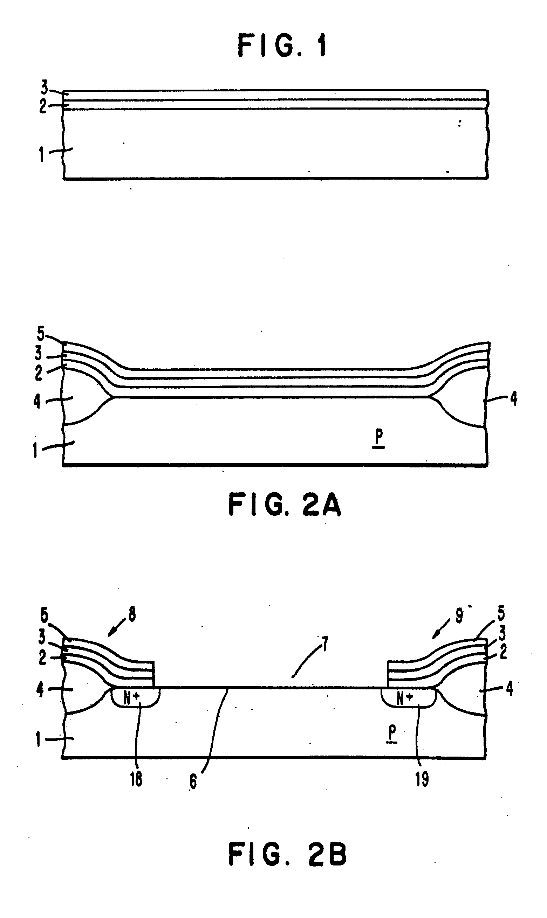

La figure 1 représente un corps semi-conducteur 1, par exemple du silicium, comportant une ligne de silicium polycristallin dopé 2. Une région de siliciure 3 est intégralement associée à la région de silicium polycristallin dopé, un métal se combinant au silicium pour former une région de siliciure. La région 3 peut être formée par conversion en siliciure d'une partie de la région de silicium polycristallin 2 ou à partir de sources indépendantes de silicium et de métal. La combinaison de ces régions 2 et 3 sera ci-après appelée « polyciure ».

L'élément d'interconnexion de polyciure 2, 3 offre simultanément les avantages des interconnexions présentant une conductivité très élevée et ayant un effet de capacité parasite réduit lorsque le polyciure d'interconnexion 2, 3 chevauche d'autres zones du dispositif semi-conducteur séparées par des isolants. Ceci est plus particulièrement dû au fait que l'élément d'interconnexion de polyciure 2, 3, n'inter-réagit pas avec les régions dopées du substrat de silicium 1. La ligne conductrice est séparée du substrat semi-conducteur par une couche d'oxyde. Un avantage caractéristique de l'élément de polyciure 2, 3 réside dans le fait qu'il peut être oxydé comme du silicium polycristallin, ce qui permet de réaliser des croisements de lignes d'interconnexion.

Il est évident qu'à mesure que croissent la densité d'intégration et le nombre des couches impliquées dans la fabrication des circuits intégrés semi-conducteurs, les avantages particuliers offerts par l'élément de polyciure 2, 3 de la présente invention deviennent de plus en plus intéressants et assurent une grande souplesse d'interconnexion.

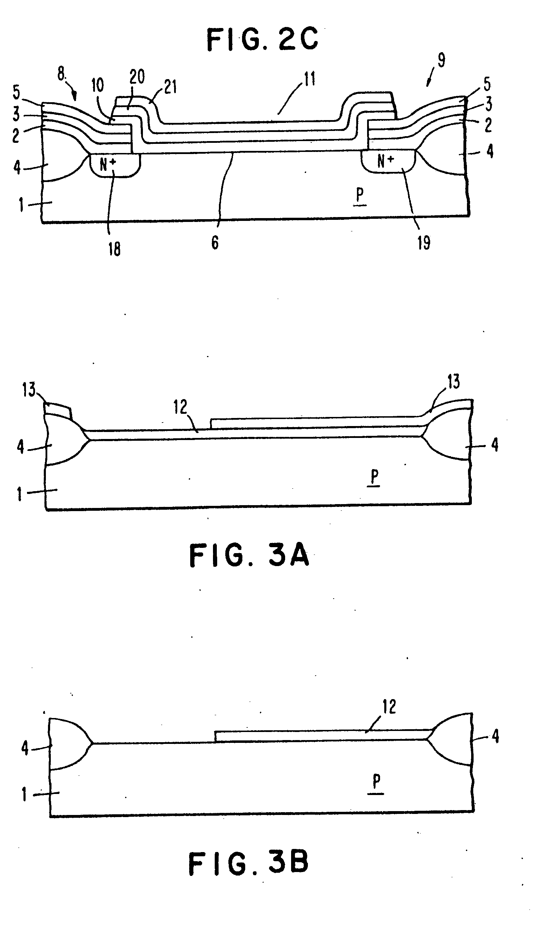

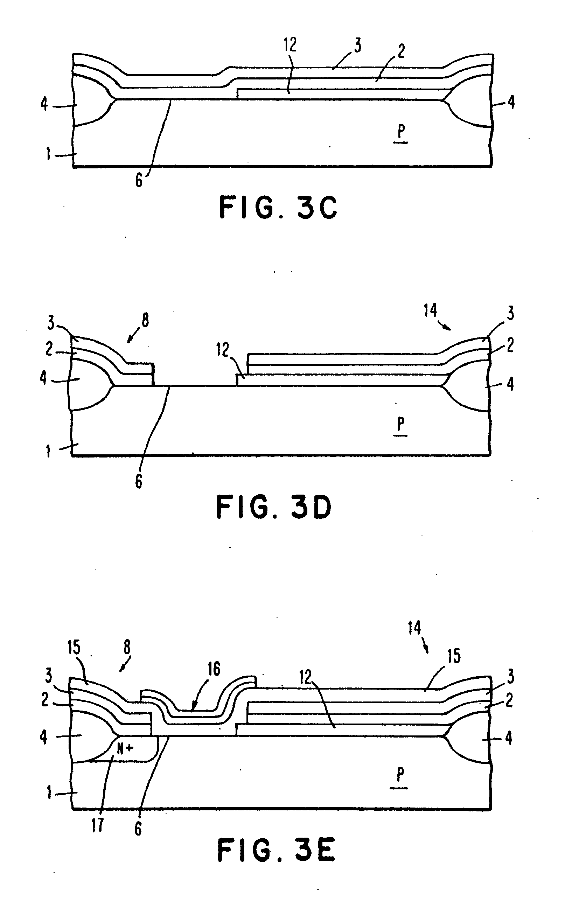

La technique d'interconnexion de circuits intégrés de la présente invention peut être utilisée dans une grande variété d'ensembles de circuits intégrés semi-conducteurs. Les figures 2 et 3 représentent l'application de l'élément d'interconnexion de l'invention à deux types classiques de structures semi-conductrices.

Les figures 2A à 2C représentent les étapes de fabrication d'un transistor à effet de champ à porte isolée comportant une isolation par oxyde encastré.

La figure 2A représente un cristal semi-conducteur 1 de conductivité du type p, comportant une région d'oxyde encastré 4 obtenue par un masque d'oxydation et dans laquelle le transistor à effet de champ doit être formé. La région d'oxyde 4 isole le dispositif à former des autres dispositifs situés dans le cristal semi-conducteur. Une couche de silicium polycristallin 2 est réalisée sur la région 4 et sur la partie exposée du cristal 1.

Certaines parties du matériau polycristallin peuvent comporter un dopant du type de conductivité n qui se diffusera ultérieurement dans le cristal 1 pour former les régions source 18 et drain 19 d'un transistor à effet de champ à porte isolée (IGFET). Une couche de siliciure 3 est ensuite formée sur la couche polycristalline 2. Le siliciure est formé ou déposé par co-évaporation, pulvérisation ou dépôt sous vide de façon qu'au cours du déroulement du procédé, ou bien le métal se combine avec le polysilicium pour former le siliciure, ou la couche 3 est formée entièrement par un mélange de métal et de silicium co-déposés. A ce sujet, une technique satisfaisante est décrite dans la demande de brevet européenne No. 784 300 030 déposée le 22 juin 1978 par la demanderesse. Les métaux les plus appropriés sont ceux qui forment des oxydes de passivation et d'isolation avec du silicium, tels que le tungstène, le molybdène, le tantale, le titane et le rhodium. Une couche de dioxyde de silicium 5 est alors formée sur la couche 3. La couche 5 peut être soit formée sur place, soit obtenue partiellement par croissance puis partiellement par dépôt soit encore obtenue uniquement par dépôt.

La figure 2B montre le déroulement d'une opération de décapage au travers d'un masque. Une ouverture 7 est aménagée dans les couches 2, 3 et 5 exposant la région 6 qui peut faire fonction de canal pour un dispositif du type à effet de champ. Après l'opération de décapage, la structure est soumise à un cycle de réchauffement pour former les régions source 18 et drain 19 par rétrodiffusion à partir du silicium polycristallin dopé 2. A cet instant, il est possible d'ajuster la tension de seuil dans la région 6. Ce procédé réduit au minimum la redistribution des impuretés du canal 6. Un autre procédé possible consiste à faire croître une mince région d'oxyde de porte, comme indiqué en 10 dans la figure 2C, pendant le cycle thermique au cours duquel les régions source 18 et drain 19 sont rétrodiffusées à partir du polysilicium 2. A la suite de cet ajustement du seuil, un ajustement plus fin peut être assuré par implantation ionique.

La figure 2C représente la formation de la porte du dispositif à effet de champ. Une première couche d'oxyde de porte 10 est formée sur le cristal 1. Puis, une deuxième couche de polyciure 20, 21 est appliquée sur l'élément 10 pour former ainsi la structure de porte 11.

La couche de polyciure 20, 21 est appliquée de façon à recouvrir les électrodes source 8 et drain 9 séparées par l'isolant 10. Les dopants et les métaux utilisés dans la couche 20, 21 peuvent être différents de ceux utilisés dans la couche de polyciure 2, 3, ce qui permet d'obtenir différentes propriétés particulièrement appropriées à la porte 11.

Il est évident que des couches de nitrure de silicium supplémentaires, qui facilitent l'application des techniques d'auto-alignement, peuvent être utilisées pour la fabrication des éléments d'interconnexion améliorés de la présente invention.

Bien que l'on ait décrit ci-dessus un procédé de fabrication simplifié de transistors à effet de champ à porte isolée (IGFET), d'autres dispositifs tels que des transistors bipolaires, pourraient être facilement fabriqués en utilisant ce procédé à couche de polyciure.

Les figures 3A à 3E illustrent la technique de la présente invention appliquée à la fabrication d'un dispositif du type à effet de champ tel qu'une cellule de mémoire. Un exemple d'un tel dispositif est décrit dans le brevet No. 1 575 946 déposé en France par la demanderesse le 19 juin 1968.

La figure 3A montre la région d'oxyde encastré dans le cristal 1, cette région définissant une zone pour le dispositif de mémoire. On fait alors croître la couche d'oxyde 12 sur la surface du cristal dans la zone délimitée par la région 4. Un matériau photo-résistant 13 est alors disposé de façon à recouvrir une partie de la couche d'oxyde 12 et une partie de la région d'oxyde encastré 4 et à laisser exposer une partie de la couche d'oxyde 12.

La figure 3B montre l'étape suivante dans laquelle une partie de la couche d'oxyde 12 est décapée, ce qui expose une partie de la surface du cristal 1, et la couche de matériau photorésistant 13 est retirée.

La figure 3C représente l'étape suivante dans laquelle une couche de polyciure 2, 3 est appliquée sur la partie restante de la couche d'oxyde 12 et sur le cristal 1.

La figure 3D représente une étape de décapage dans laquelle le cristal du canal 6 est exposé. L'interconnexion 8 est maintenant définie et joue le rôle de contact source.

La figure 3E montre une structure de porte formée en faisant croître une couche d'oxyde 15 correspondant à l'élément 10 de la figure 2C. Pendant cette oxydation, la structure de polyciure 2, 3 est également oxydée et la région source 17 est formée par rétrodiffusion à partir de la partie de silicium polycristallin dopé 2 de l'élément de polyciure ohmiquement connecté au contact d'interconnexion 8. Un deuxième élément de polyciure 16 est alors formé pour compléter la structure de porte. La structure finale correspond à la structure du transistor du type FET telle que décrite dans le brevet No. 1 575 946 cité précédemment.

On a décrit ci-dessus une technique de fabrication de dispositifs d'interconnexion améliorée, ces dispositifs étant formés de silicium polycristallin associé à un siliciure et faisant fonction à la fois de contact et de lignes conductrices, ce qui permet la réalisation de structures de porte FET simplifiées.

On notera que les structures du type à effet de champ améliorées de la présente invention impliquant à la fois des contacts et des portes de polyciure, une conductivité améliorée et une capacité parasite réduite, sont réalisées sans étapes de traitement préjudiciables telles que des opérations importantes d'implantation ionique et de diffusion.

Bien que l'on ait décrit dans ce qui précède et représenté sur les dessins les caractéristiques essentielles de l'invention appliquées à deux structures semi-conductrices, il est évident que l'homme de l'art peut les appliquer à d'autres structures semi-conductrices et à des variantes par exemple en remplaçant l'oxyde par d'autres matériaux isolants tels que le nitrure de silicium et y apporter toutes modifications de forme ou de détail qu'il juge utiles, sans pour autant sortir du cadre de ladite invention.

**Revendications**

1. Dispositif d'interconnexion de circuit intégré semi-conducteur du genre dans lequel la capacité parasite est réduite lors du chevauchement d'éléments de forte conductivité et du genre dans lequel le circuit intégré se compose de régions semi-conductrices et de régions isolantes (4) séparant au moins certaines régions semi-conductrices, ce dispositif étant caractérisé en ce qu'il comporte à la fois :

au moins un premier élément de forte conductivité, composé de silicium polycristallin dopé (2) associé à un siliciure de métal (3), cet élément agissant comme un conducteur connecté ohmiquement auxdites régions semi-conductrices (18, 19),

au moins un second élément de forte conductivité, composé de silicium polycristallin dopé (20) associé à un siliciure de métal (21), cet élément recouvrant au moins une partie desdites régions isolantes (4), agissant comme un conducteur et chevauchant au moins une partie dudit premier élément de forte conductivité dont il est séparé par une couche isolante (10).

2. Dispositif d'interconnexion pour élément semi-conducteur à effet de champ du genre dans lequel l'élément à effet de champ comporte une région de canal (6) située dans un corps semi-conducteur (1), une porte située au-dessus du canal, une région de source adjacente (18) à la région de canal, et dans lequel la capacité parasite entre conducteur de source et conducteur de porte est réduite, ce dispositif étant caractérisé en ce qu'il comporte à la fois :

au moins un premier élément (8) de forte conductivité, composé de silicium polycristallin dopé (2) associé à un siliciure de métal (3), cet élément agissant comme un conducteur connecté ohmiquement à la région de source (18),

au moins un second élément de forte conductivité, composé de silicium polycristallin dopé (20) associé à un siliciure de métal (21), cet élément agissant comme un conducteur de porte et étant déposé sur une couche d'oxyde (10) recouvrant la région de canal (6), ce deuxième élément chevauchant au moins en partie ledit premier élément dont il est séparé par l'intermédiaire d'une couche isolante (10).

3. Dispositif selon la revendication 2, caractérisé en ce que l'élément semi-conducteur à effet de champ comporte également une région de drain (19) adjacente à la région de canal (6) et opposée à la région de source (18), et en ce qu'un desdits premiers éléments (8, 9) est en contact ohmique avec la région de drain (19).

4. Dispositif d'interconnexion de structure semi-conductrice du genre dans laquelle la structure semi-conductrice comporte :

un cristal semi-conducteur (1) comportant une région exposée et entourée par une région d'oxyde encastrée (4),

une première couche d'oxyde (12) recouvrant une partie de ladite région exposée et ne laissant ainsi qu'une région réduite exposée (6),

une région de source (17) située près de la région d'oxyde encastrée (4), le dispositif étant caractérisé en ce qu'il comporte en outre :

deux éléments (8, 14) de forte conductivité, composés de silicium polycristallin dopé (2) associé à un siliciure de métal (3), le premier élément (14) recouvrant ladite couche d'oxyde (12) et le second élément (8) étant en contact ohmique avec la région de source (17),

un contact de porte (16) situé au-dessus de ladite région réduite exposée (6) par l'intermédiaire d'une couche d'oxyde (15) et comportant une couche de silicium polycristallin et une couche de siliciure, ces deux dernières couches chevauchant au moins en partie lesdits deux éléments (8, 14) de forte conductivité dont elles sont séparées par l'intermédiaire d'une couche isolante (15).

5. Dispositif d'interconnexion selon la revendication 4, caractérisé en ce que la structure semi-conductrice étant du genre structure de mémoire, la région d'oxyde (4) délimite la zone active de la structure de mémoire, cette zone active comportant une zone d'emmagasinage recouverte par la couche d'oxyde (12), une région de source (17) et une zone de porte (6).

6. Procédé de fabrication d'un dispositif d'interconnexion pour un transistor à effet de champ, du genre dans lequel la capacité parasite entre conducteurs de source et drain et conducteur de porte est réduite, caractérisé en ce qu'il comprend les étapes suivantes :

la création d'une région cristalline semi-conductrice (1) d'un premier type de conductivité, cette région étant délimitée par une région d'oxydation encastrée (4),

le dépôt, sur lesdites régions cristalline et d'oxydation, d'une couche de silicium polycristallin dopé (2) dont le dopage est d'un type de conductivité opposé à celui dudit cristal,

le dépôt d'une couche de siliciure métallique (3) sur ladite couche de polysilicium dopé (2),

le dépôt d'une couche de passivation (5) sur ladite couche de siliciure,

la formation d'une ouverture (7) dans lesdites couches pour exposer ledit cristal semi-conducteur entre les régions de source et de drain, afin de définir la région de canal (6) et les conducteurs de source (8) et de drain (9),

la formation des régions de source (18) et de drain (19) dans ledit cristal semi-conducteur par rétro-diffusion des impuretés présentes dans ladite couche polycristalline,

la formation d'une structure de porte (11) dans ladite ouverture comportant une électrode constituée par une couche de silicium polycristallin (20) associé à un siliciure de métal (21) recouvrant une couche d'oxyde (10), l'électrode de porte (20, 21) chevauchant en partie ladite couche de polysilicium dopé (2) recouverte de la couche de siliciure métallique (3) dont elle est séparée par l'intermédiaire de la couche isolante (10).

7. Procédé selon la revendication 6, caractérisé en ce que le métal du siliciure métallique (21) est un métal formant un oxyde de passivation et d'isolation avec le silicium.

8. Procédé selon l'une des revendications 6 ou 7, caractérisé en ce que l'étape de dépôt d'une couche de silicium métallique (21) comporte au moins une étape dans laquelle on fait réagir ledit métal avec le silicium polycristallin dopé, ce métal et le silicium polycristallin dopé étant alors évaporés ensemble pour obtenir la couche de dépôt.

**Claims**

1. An interconnection device for integrated semiconductor circuits of the type wherein the parasitic capacitance is reduced when high conductivity members overlap and of the type wherein the integrated circuit is composed of semiconductor regions and insulation regions (4) separating at least some of the semiconductor regions, said device being characterized in that it comprises :

at least a first high conductivity member composed of a doped polycrystalline silicon portion (2) associated with a metal silicide portion (3), said member acting as a conductor ohmically connected to said semiconductor regions (18, 19), and

at least a second high conductivity member composed of a doped polycrystalline silicon portion (20) associated with a metal silicide portion (21), said second member extending over at least a portion of said insulation regions (4), acting as a conductor, and overlapping at least a portion of said first high conductivity member from which it is separated by an insulation layer (10).

2. An interconnection device for field effect semiconductor devices of the type wherein the field effect device includes a channel (6) in a semiconductor body (1), a gate member over said channel, a source region (18) adjacent to said channel, and wherein the parasitic capacitance between the source conductor and the gate conductor is reduced, said interconnection device being characterized in that it comprises :

at least a first high conductivity member (8) composed of a doped polycrystalline silicon portion (2) associated with a metal silicide portion (3), said first member acting as a conductor ohmically connected to said source region (18), and

at least a second high conductivity member composed of a doped polycrystalline silicon portion (20) associated with a metal silicide portion (21), said second member acting as a gate conductor extending over an oxide layer (10) over said channel (6) and overlapping partially at least said first member from which it is separated by an insulation layer (10).

3. A device according to claim 2, characterized in that the field effect semiconductor device further includes a drain region (19) adjacent to the channel (6) and opposite the source region (18), and in that one of said fist high conductivity members (8, 9) is in ohmic contact with the drain region (19).

4. An interconnection device for semiconductor structures of the type wherein the semiconductor structure comprises :

a semiconductor crystal (1) having an exposed region thereof surrounded by a recessed oxide region (4),

a first oxide layer (12) extending over a portion of said exposed region, leaving a reduced exposed region (6),

a source region (17) located near said recessed oxide region (4), said interconnection device being characterized in that it further comprises :

two high conductivity members (8, 14) composed of a doped polycrystalline silicon portion (2) associated with a metal silicide portion (3), with the first member (14) extending over said oxide layer (12) and with the second member (8) being in ohmic contact with the source region (17), and

a gate contact (16) located aver an oxide layer (15) extending over said reduced exposed region (6), and comprising a polycrystalline silicon layer and a silicide layer both of which overlap partially at least said two high conductivity members (8, 14) from which they are separated by an insulation layer (15).

5. An interconnection device according to claim 4, characterized in that semiconductor structure is a memory structure wherein the oxide region (4) delineates an active memory structure area comprising a storage area over which the oxide layer (12) extends, a source region (17) and a gate region (6).

6. A method of fabricating an interconnection device for field effect transistors or the type wherein the parasitic capacitance between the source and drain conductors and the gate conductor is reduced, characterized in that it includes the steps of :

forming a semiconductor crystalline region (1) of a first type of conductivity, said region being delineated by a recessed oxidation region (4),

applying aver said crystalline and oxidation regions a doped polycrystalline silicon layer (2), the doping being of opposite conductivity type to said crystal,

applying a metal silicide layer (3) over said doped polysilicon layer (2),

applying a passivation layer (5) over said silicide layer,

forming an opening (7) through said layers to expose said semiconductor crystal between the source and drain regions to define the channel (6), the source conductor (8) and the drain conductor (9),

diffusing the source region (18) and the drain region (19) into said semiconductor crystal out of the impurities present in said polycrystalline layer, and

forming a gate structure (11) in said opening comprised of an electrode consisting of a polycrystalline silicon layer (20) associated with metal silicide (21) over an oxide layer (10), with the gate electrode (20, 21) partially overlapping said doped polysilicon layer (2) over which the metal silicide layer (3) extends and from which it is separated by the insulation layer (10).

7. A method according to claim 6, characterized in that the metal in the metal silicide (21) forms a passivating and insulating oxide with silicon.

8. A method according to claim 6 or 7, characterized in that the step of forming a layer of metal silicide (21) involves at least one step of reacting said metal with said doped polycrystalline silicon and then coevaporating said metal along with said doped polycrystalline silicon to provide said layer.

**Ansprüche**

1. Verbindungsvorrichtung fuer integrierte Halbleiterschaltungen, in den die parasitaere Kapazitaet im Falle von Ueberlappung mit stark leitfaehigen Elementen begrenzt ist, und in der die Halbleiterschaltung aus halbleitenden Bereichen und Isolierungsbereichen besteht, wo die Vorrichtung dadurch gekennzeichnet ist, dass sie zugleich aufweist :

mindestens ein erstes stark leitfaehiges Element aus einem dotierten mit einem Metallsilicid (3) gekoppelten polykristallinen Silizium (2), das als ein ohmiger weise mit den halbleitenden Bereichen (18, 19) verbundener Leiter wirkt,

mindestens ein zweites stark leitfaehiges Element aus einem dotierten mit einem Metallsilicid (21) gekoppelten polykristallinen Silizium (20), wobei dieses Element mindestens einen Teil der Isolierungsbereichen (4) ueberlappt, als ein Leiter wirkt und mindestens einen Teil des ersten stark leitfaehigen Elements ueberlappt, von dem es mit einer Zwischenisolierungsschicht (10) getrennt ist.

2. Verbindungsvorrichtung fuer integrierte Feldeffekt-Halbleiterschaltungen, in den das Feldeffektelement eine in einem Halbleiter (1) vorliegenden Kanalzone (6), ein ueber der Kanalzone angeordnetes Gate und eine an der Kanalzone anliegenden Sourcezone (18) aufweist, und in den die parasitaere Kapazitaet zwischen dem Sourceleiter und dem Gateleiter begrenzt ist, wo die Vorrichtung dadurch gekennzeichnet ist, dass sie zugleich aufweist :

mindestens ein erstes stark leitfaehiges Element (8) aus einem dotierten mit einem Metallsilicid (3) gekoppelten polykristallinen Silizium (2) das als ein ohmiger weise mit dem halbleitenden Bereich (18) verbundener Leiter wirkt,

mindestens ein zweites stark leitfaehiges Element, das aus einem dotierten mit einem Metallsilicid (21) gekoppelten polykristallinen Silizium (20) besteht, wobei dieses als ein Gateleiter wirkende Element auf eine die Kanalzone bedeckende Oxydschicht (10) angeordnet ist, und wobei es mindestens das erste stark leitfaehige Element teilweise ueberlappt, von dem es mit einer Zwischenisolierungsschicht (10) getrennt ist.

3. Vorrichtung nach Anspruch 2, dadurch gekennzeichnet, dass das Feldeffekt-Halbleiterelement auch eine an der Kanalzone (6) anliegende und der Sourcezone (18) gegenueberstehende Drainzone (19) aufweist, und dass ein der ersten Elemente (8, 9) einen ohmischen Kontakt mit der Drainzone (19) hat.

4. Verbindungsvorrichtung einer halbleitenden Struktur, in der die letztere aufweist :

einen halbleitenden Kristall (1) mit einem freigelegten und von einer eingelegten Oxydschicht umgegebenen Bereich (4),

eine erste Oxydschicht (12), die einen Teil des freigelegten Bereichs ueberlappt, und nur einen begrenzten freigelegten Teilbereich (6) frei laesst.

eine nah an dem eingelegten Oxydbereich (4) liegenden Sourcezone (17), wobei die Vorrichtung dadurch gekennzeichnet ist, dass sie ausserdem aufweist :

zwei stark leitfaehige Elemente (8, 14) aus dotiertem und mit einem Metallsilicid (3) gekoppeltem polykristallinen Silizium (2), wobei das erste Element (14) die Oxydschicht (12) ueberlappt, und das zweite Element (8) einen ohmischen Kontakt mit der Sourcezone (17) hat,

einen Gatekontakt (16), der mittels einer Zwischenoxydschicht ueber den begrenzten freigelegten Bereich angeordnet ist und eine polykristalline Siliziumschicht und eine Silicidschicht aufweist, wobei die beide letzten Schichten mindestens die zwei stark leitfaehigen Elemente (8, 14) ueberlappen, von denen sie mittels einer Zwischenoxydschicht (15) getrennt sind.

5. Verbindungsvorrichtung nach Anspruch 4, dadurch gekennzeichnet, dass die halbleitende Struktur eine Speicherstruktur ist, in der der Oxydbereich (4) die aktive Zone der Speicherstruktur begrenzt, wobei diese aktive Zone eine von der Oxydschicht (12) bedeckten Speicherungszone (12), eine Sourcezone (17) und eine Gatezone (6) aufweist.

6. Verfahren zur Herstellung einer Verbindungsvorrichtung fuer einen Feldeffekt-Transistor, in der die parasitaere Kapazitaet zwischen den Source- und Drainleitern und dem Gateleiter begrenzt ist, dadurch gekennzeichnet, dass es die folgenden Schritte aufweist :

Erzeugung eines kristallinen halbleitenden Bereich (1) mit einem ersten Typ von Leitfaehigkeit, wobei dieser Bereich von einem eingelegten Oxydierungsbereich (4) beschraenkt ist,

Aufbringung einer dotierten polykristallinen Siliziumschicht (2), dessen Leitfaehigkeitstyp der Dotierung dem des Kristalls entgegengesetzt ist, auf den kristallinen Bereichen und den Oxiedierungsbereichen,

Aufbringung einer metallischen Silicidschicht (3) auf der dotierten Schicht aus polykristallinem Silizium (2),

Aufbringung einer Passivierungsschicht (5) auf der Silicidschicht,

Bildung einer Oeffnung (7) durch die Schichten zur Freilegung des zwischen den Source- und Drainzonen angeordneten Kristalls, so dass die Kanalzone (6) und die Source- und Drainleiter (8, 9) definiert werden,

Bildung der Source- und Drainzonen (18, 19) in dem halbleitenden Kristall durch Eindiffundieren der in der polykristallinen Schicht vorliegenden Stoerelemente,

Bildung einer eine Elektrode einschliessende Gatestruktur (11) in der Oeffnung, wobei die Elektrode aus einer polykristallinen Siliziumschicht (20) besteht, die mit einem eine Oxydschicht (10) ueberlappende Metallsilicid (21) gekoppelt ist, wobei das Elektrode-Gate (20, 21) die dotierte polykristalline Siliziumschicht (2) teilweise ueberlappt, die von einer metallischen Silicidschicht (3) bedeckt und von der letzteren mit einer Zwischenoxydschicht (10) getrennt ist.

7. Verfahren nach Anspruch 6, dadurch gekennzeichnet, dass der Metall des Metallsilicids (21) ein Metall ist, der mit dem Silizium ein Passivierungs- und Isolierungsoxid bildet.

8. Verfahren nach irgendeinem der Ansprueche 6 oder 7, dadurch gekennzeichnet, dass der Verfahrensschritt zur Aufbringung einer Metallsilicidschicht (21) mindestens einen Schritt aufweist, bei dem der Metall in Anwesenheit des dotierten polykristallinen Siliziums umgesetzt wird, wobei der Metall und das dotierte polykristalline Silizium zur Bildung des Ueberzugs zugleich aufgedampft werden.

# FIG. 1

# FIG. 2A

# FIG. 2B

# FIG. 2C

# FIG. 3A

# FIG. 3B

FIG. 3C

FIG. 3D

FIG. 3E